# EUROPEAN PATENT APPLICATION

(11) **EP 2 701 472 A1**
(43) Date of publication of application: **26.02.2014**
(21) Application number: 12774530.5
(22) Date of filing: 06.01.2012
(51) Int. Cl.: H05K 1/11, H05K 1/02, H05K 1/14

(54) **WIRING SUBSTRATE**

(30) Priority: 19.04.2011 JP 2011093315
(71) Applicant: Kabushiki Kaisha Toyota Jidoshokki, Kariya-shi, Aichi 448-8671 (JP)
(72) Inventor: SHIMADU, Hitoshi, Kariya-shi Aichi-ken (JP); SAWADA, Takehiko, Kariya-shi Aichi-ken (JP); HAYAKAWA, Takahiro, Nagoya-shi Aichi-ken (JP); ASAI, Tomoaki, Nagoya-shi Aichi-ken (JP); YAMAUCHI, Ryou, Hashima-shi Gifu-ken 501-6233 (JP)
(74) Representative: TBK
(86) International application number: PCT/JP2012/050139
(87) International publication number: WO 2012/144238

(57) **Abstract**

A wiring substrate (10, 40, 60. 80) includes a wiring pattern (13, 21, 41, 43, 65, 83a, 83b, 83c) and an insulating layer (11, 26, 48, 81) to which the wiring pattern is fixed. The insulating layer includes an edge. The wiring pattern (13, 21, 41, 43, 65, 83a, 83b, 83c) includes a joint portion (14, 44, 66) connected with the insulating layer (11, 26, 48, 81) and an extended portion (45, 45, 67, 85) that extends from the joint portion (14, 44, 66) and protrudes from the edge of the insulating layer (11, 26, 48, 81). The insulating layer (11, 26, 48, 81) or the joint portion (14, 44, 66) includes an outermost surface. A connection terminal (T, T1) is provided by bending the extended portion (45, 45, 67, 85) so that a part of the extended portion (45, 45, 67, 85) is protruded from the outermost surface of the insulating layer (11, 26, 48, 81) or the joint portion (14, 44, 66).

## Description

### TECHNICAL FIELD

The present invention relates to a wiring substrate that is preferably used for an electronic device in an electric vehicle or a hybrid vehicle.

### BACKGROUND ART

Conventionally, as a technique pertaining to a wiring substrate, for example, there is a power supply as disclosed in Patent Document 1. In this power supply, a power board and a control board are integrally connected to each other and electrically connected via hard wires in the form of metal rods. Alternatively, the power board and the control board are connected by providing a connector in the power board and inserting the control board in the connector.

As another prior art, for example, a connecting structure between the print boards as disclosed in Patent Document 2 is known. In this connecting structure, a first print board includes an insulating plate, pairs of upper and lower lands and through-holes each extends through the corresponding pair of the upper and lower lands. A second print board includes an insulating plate and plug terminals that protrude at one edge of the insulating plate. Each plug terminal includes a protrusion that is fittable into the through-hole in the first print board and a connecting electrode pattern provided on one side of the protrusion. By fitting the plug terminals of the second print board into the corresponding through-holes in the first print board and then solder bonding the lower lands with the connecting electrode patterns, the second print board are electrically and mechanically connected to the first print board at a certain crossing angle.

As another prior art, for example, a connecting structure for connecting substrates or boards is disclosed in Patent Document 3. In this connecting structure, either a male connector or female connector is mounted on a substrate, and the substrate includes a guiding portion having a predetermined length to guide another substrate when the substrates are connected. The other substrate includes a notch in the position corresponding to the guiding portion so that the guiding portion passes through the notch. When the guiding portion passes through the notch, the male connector and the female connector are positioned to face to each other. Thus, work effectiveness is improved when the male connector and female connector are connected.

In other prior art, for example, a structure for holding printed circuit boards in Patent Document 4 is disclosed. In this structure, protrusions each having a head are provided on both sides of a male connector mounted on a lower substrate. In addition, a female connector mounted on an upper substrate and holes are provided on both sides of the female connector at positions corresponding respectively to the heads. The diameter of each hole is smaller than that of each head. By elastically deformation, the head is detachably fittable into the corresponding hole. Thus, the lower substrate and the upper substrate can be attached or detached easily without using a tool.

### PRIOR ART DOCUMENTS

### PATENT DOCUMENTS

Patent Document 1: Japanese Laid-Open Patent Publication No. 2009-33882
Patent Document 2: Japanese Laid-Open Patent Publication No. 2001-57465
Patent Document 3: Japanese Laid-Open Patent Publication No. 2008-10592
Patent Document 4: Japanese Laid-Open Patent Publication No. H5-218669

### SUMMARY OF THE INVENTION

### PROBLEMS TO BE SOLVED BY THE INVENTION

However, in prior art disclosed in Patent Documents 1, 3 and 4, additional members such as hardwires, connectors, guides or protrusions are required to connect the substrates or to position the substrates. When such additional members are used, for example, the number of parts increases, longer time for assembling is required, and costs for manufacturing a wiring substrate increase. In addition, space for the additional members is required in the substrate. Thus, miniaturization of the wiring substrate is prevented.

Meanwhile, in Patent Document 2, the substrates can be connected each other without additional members. However, since the plug terminals provided at the edge of one of the substrates are fitted into the corresponding through-holes, a certain crossing angle between the substrates is required. Thus, it is impossible to position the two substrates in a manner that the surfaces of the two substrates are arranged in parallel.

An object of the present invention is to provide a wiring substrate that can be connected with another member without increasing the number of parts and that can be positioned with respect to the other member without the orientation restriction.

### MEANS FOR SOLVING THE PROBLEM

According to one aspect of the present invention, a wiring substrate comprising a wiring pattern and an insulating layer to which the wiring pattern is fixed. The insulating layer includes an edge. The wiring pattern includes: a joint portion connected with the insulating layer; and an extended portion that extends from the joint portion and protrudes from the edge of the insulating layer. The insulating layer or the joint portion includes an outermost surface. A connection terminal is provided by bending the extended portion so that a part of the extended portion is protruded from the outermost surface of the insulating layer or the joint portion.

According to another aspect, the insulating layer includes an opening that extends through the insulating layer. The extended portion is located at the opening.

According to another aspect, the connection terminal is bent in a direction perpendicular to the outermost surface of the insulating layer or the joint portion.

According to another aspect, the connection terminal has a distal tip. The extended portion has sides and each side has a tapered portion so that the width of the extended portion becomes smaller toward the distal tip of the connection terminal.

According to another aspect, the connection terminal has a distal portion. The extended portion includes a wide portion having a greater width than the distal portion of the connection terminal.

According to another aspect, the connection terminal is connected with another member by soldering.

According to another aspect, the wiring pattern is a pressed conductive plate and joined with the insulating layer with an adhesive agent.

According to another aspect, the extended portion has a recess at the position to be bent.

According to another aspect, the recess includes a striking or a wedge-shaped groove.

According to another aspect, the wiring pattern is made of a metal plate.

According to another aspect, a mounting pad is formed in the wiring pattern.

According to another aspect, the wiring pattern includes a wiring pattern in one section fixed to the insulating layer and a wiring pattern in another section fixed to the insulating layer. The connection terminal forms a jumper line connecting the wiring pattern in one section and the wiring pattern in another section.

According to another aspect, the connection terminal forming the jumper line bridges over a wiring pattern at a certain distance that is different from the wiring pattern in one section and the wiring pattern in another section.

### BRIEF DESCRIPTION OF THE DRAWINGS

Fig. 1 is a longitudinal sectional view illustrating the connecting structure of a wiring substrate according to a first embodiment and another substrate;
Fig. 2 is a plan view illustrating the wiring substrate;
Fig. 3 is a cross sectional view taken along the line A-A of Fig. 2;
Figs. 4A to 4C illustrate longitudinal sectional views illustrating a manufacturing process for the wiring substrate;
Figs. 5A and 5B illustrate longitudinal sectional views illustrating a manufacturing process for the wiring substrate;
Fig. 5C illustrates a longitudinal sectional view illustrating a process for connecting the wiring substrate with another substrate;
Figs. 6A and 6B illustrate longitudinal sectional views illustrating a wiring substrate according to a second embodiment;
Figs. 7A and 7B illustrate longitudinal sectional views illustrating a wiring substrate according to a third embodiment;
Fig. 8A, 8B and 8C are a plan view, a side view and front view of a wiring substrate in another embodiment;
Figs. 9A and 9B are a plan view and a side view of a wiring substrate in another embodiment;
Fig. 10 is a front view illustrating a wiring substrate in another embodiment;
Fig. 11 is a partial front view illustrating a wiring substrate in another embodiment; and
Fig. 12 is a partial front view illustrating a wiring substrate in another embodiment.

### EMBODIMENTS OF THE INVENTION

### First Embodiment

A wiring substrate according to a first embodiment of the invention will be described with reference to the drawings.

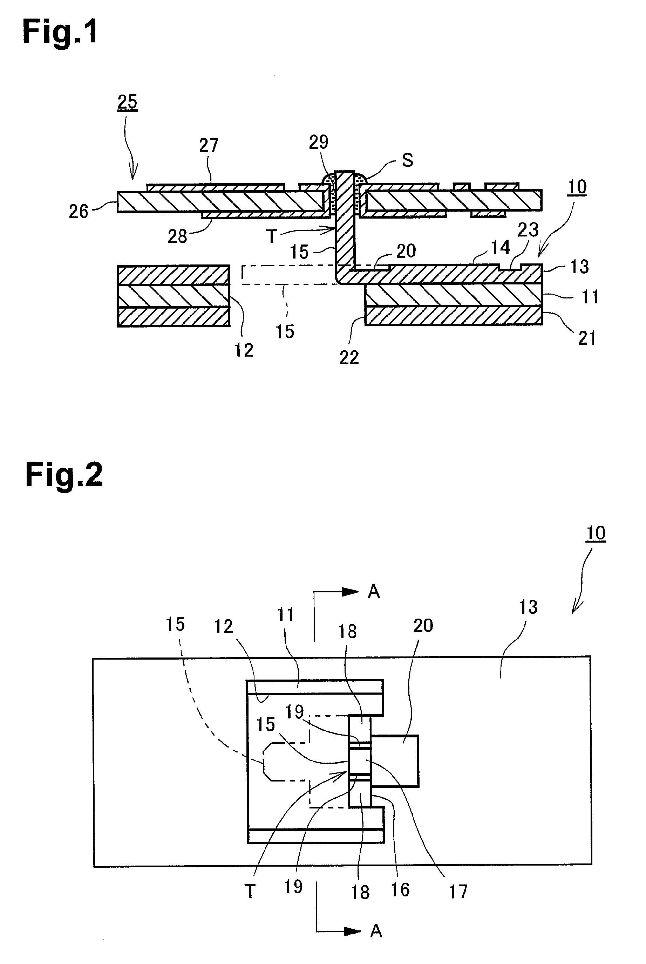

A wiring substrate 10 of the first embodiment as illustrated in Fig. 1 is a power board controlled by, for example, a control board of a high-output motor of an electric vehicle or a hybrid vehicle. The wiring substrate 10 is fixed to a non-illustrated housing via a heat dissipation sheet. In the wiring substrate 10, as illustrated in Fig. 1, a front wiring pattern 13 in the form of plate is fixed to the front surface of the insulating layer 11 via a non-illustrated adhesive sheet and a back wiring pattern 21 is fixed to the back surface of the insulating layer 11 via a non-illustrated adhesive sheet. That is, the wiring substrate 10 are integrally formed from the insulating layer 11, the front wiring pattern 13 and the back wiring pattern 21. The wiring substrate 10 of Fig. 1 is connected with a substrate 25, which is another member, via a connection terminal T.

The insulating layer 11 in the wiring substrate 10 is made by hardening a prepreg, which is a core (e.g., a core made of glass-cloth) impregnated with a resin (e.g., epoxy). For example, the thickness of the insulating layer 11 is set to 0.4 to 4.0 mm, more preferably 0.5 to 0.8 mm. The insulating layer 11 includes a rectangular opening 12 that extends from one side (front surface) to the other side (rear surface) of the insulating layer 11. The opening 12 is formed by punching the insulating layer 11 by a press.

The adhesive sheet(s) used for the wiring substrate 10 is an adhesive sheet including an epoxy adhesive agent as a main component. The epoxy adhesive agent has excellent adhesiveness, thermal conductivity and insulation properties compared to other adhesive agents. The thickness of the adhesive sheet is set to 100 µm or less, more preferably set to 40 to 50 µm. An adhesive agent for the adhesive sheet is not limited to the epoxy adhesive agent as described above but may be other adhesive agents such as a silicone adhesive agent or a prepreg including no glass fibers. Alternatively, instead of or in addition to an adhesive sheet, an adhesive agent of the coating type may be used to fix the front wiring pattern 13 and the back wiring pattern 21 to the insulating layer 11.

The front wiring pattern 13 and the back wiring pattern 21 are conductive plates formed by punching press of copper plates as raw materials. The wiring patterns 13, 21 are formed by a punching press with copper plates having a thickness of for example, 0.4 to 2.0 mm, more preferably 0.5 mm. In the first embodiment, a metal plate having a predetermined thickness is used as a circuit pattern in the form of plate to support large electric current (e.g., 50 to 180 A). As defined in the context of the first embodiment, a metal plate refers to a plate that has a thickness to allow the metal plate to be punched out and to maintain its own shape without adding an external force. Moreover, as defined in the context of the first embodiment, concept of the metal plate excludes the plate that need etching and does not maintain it own shape. Each wiring pattern 13, 21 is not limited to the copper plate but may be made of a conductive material such as an aluminum plate. In addition, the wiring substrate 10 is not limited to use for large electric current but may be used for weak electric currents (several mA).

As illustrated in Fig. 1 and Fig. 2, the front wiring pattern 13 includes a joint portion 14 that overlaps the insulating layer 11 and an extended portion 15 that extends from the joint portion 14 toward the opening 12 of the insulating layer 11. The joint portion 14 is a portion fixed to the insulating layer 11 via the adhesive sheet. The extended portion 15 is a nonoverlapping portion that does not join with the insulating layer 11. By bending the extended portion 15, a connection terminal T in the front wiring pattern 13 is produced.

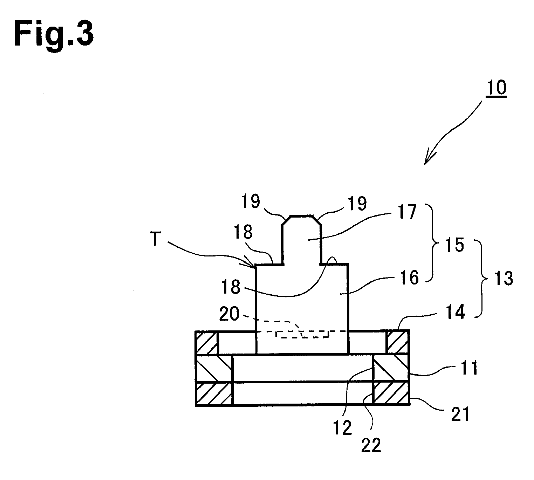

As illustrated in Fig. 3, the extended portion 15 includes a base 16 that communicates with the joint portion 14 and a distal portion 17 having a narrower width than the base 16. A step 18 is formed between the base 16 and the distal portion 17. The step 18 supports the substrate 25 and maintains a predetermined distance between the wiring substrate 10 and the substrate 25. The base 16 is a wider portion having a greater width than the distal portion 17. In the position where a portion of the base 16 is to be bent, a striking 20 is formed as a recess for correcting the shape to prevent springback. The striking 20 is formed at the time of punching press of the front wiring pattern 13. The distal portion 17 of the extended portion 15 includes beveled and tapered portions 19. Each tapered portion 19 is formed so that the width of the distal portion 17 becomes smaller toward the distal tip. Each tapered portion 19 serves as a guide for guiding the connection terminal T relative to the connecting portion of the substrate 25.

By bending the extended portion 15 perpendicularly on the way in the longitudinal direction of the base 16, the distal end of the extended portion 15 orients upward and protrudes from the surface of the wiring substrate 10, more specifically, the outermost surface of the front wiring pattern 13. The bending of the extended portion 15 is conducted after the integration of the insulating layer 11, the front wiring pattern 13 and the back wiring pattern 21. Provided that the bending position of the extended portion 15 is denoted as P, the extended portion 15 includes a non-displaced portion from the proximal tip to the bending position P and a bend displaced portion from the bending position P to the distal tip. The non-displaced portion is formed from a part of the base 16 and the displaced portion is formed from the remaining part of the base 16 and the distal portion 17. In this embodiment, the length or height of the displaced portion of the extended portion 15 is 2.0 mm. However, the length of the displaced portion is not limited to the above value and may be set depending on the requirements of the wiring substrate 10 or the substrate 25. When the surface of the wiring substrate is not formed from the joint portion but formed from the insulating layer, the distal tip of the extended portion protrudes from the surface of the insulating layer (i.e., the outermost surface).

Next, the back wiring pattern 21 will be described. The back wiring pattern 21 of this embodiment is fixed to the lower surface of the insulating layer 11 with the adhesive sheet. Unlike the front wiring pattern 13, the back wiring pattern 21 does not includes an extended portion but includes an opening 22 that has substantially the same shape as the opening 12 in the insulating layer 11. The insulating layer 1 has the edge facing an opening 12 and may conduct electricity between the front wiring pattern 13 and the back wiring pattern 21.

The wiring substrate 10 of this embodiment is connected to the substrate 25, which is another member, via the connection terminal T. The substrate 25 is formed by integration of an insulating layer 26, a front wiring pattern 27 and a back wiring pattern 28. The substrate 25 includes an insertion hole 29 through which the connection terminal T of the wiring substrate 10 is insertable. Only the distal portion 17 of the extended portion 15 forming connection terminal T is insertable into the insertion hole 29. Solder S is filled in a gap between the distal 17 inserted in the insertion hole 29 and the substrate 25. The solder S electrically connects the connection terminal T and the substrate 25. Fixation of the connection terminal T with the substrate 25 allows electrical conduction between the wiring substrate 10 and the substrate 25 and electrical conduction between the front wiring pattern 27 and back wiring pattern 28 in the substrate 25.

Next, a manufacturing process of the wiring substrate 10 according to the first embodiment will be explained. The manufacturing process of the wiring substrate 10 includes a patterning step, a step of forming an insulating layer, a joint step, and a step of bending a pattern. The patterning step is a step in which the front wiring pattern 13 and the back wiring pattern 21 are formed from copper plates as material by punching with a press. The step of forming an insulating layer is a step in which a prepreg is thermally hardened to form the insulating layer 11. The joint step is a step in which the front wiring pattern 13 and the back wiring pattern 21 are fixed to the insulating layer 11 via respective adhesive sheets to integrate the insulating layer 11, the front wiring pattern 13 and the back wiring pattern 21. The step of bending a pattern is a step in which, after the joint step, the extended portion 15 of the front wiring pattern 13 is bent to form a connection terminal T.

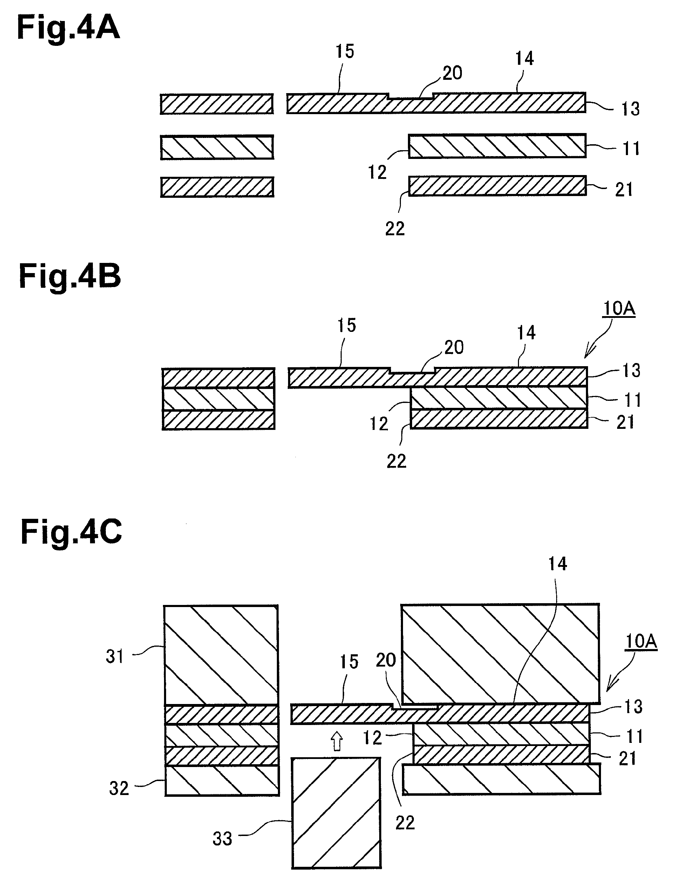

As illustrated in Fig. 4A, the insulating layer 11, the front wiring pattern 13 and the back wiring pattern 21 are preformed and prepared before the joint step. The insulating layer 11 is formed in the step of forming an insulating layer by hardening a pregpreg which is a core (e.g., a core made of glass-cloth) impregnated with a resin (e.g., epoxy). In this embodiment, the opening 12 is formed by punching the resulting insulating layer 11 with a press.

Copper plates having a predetermined shape are prepared as the raw materials of the front wiring pattern 13 and the back wiring pattern 21. In the patterning step of the front wiring pattern 13, the copper plate as a raw material is pressed into the front wiring pattern 13 having the joint portion 14 and the extended portion 15. In pressing, the striking 20, which is produced by a strike process to correct the shape for preventing springback, the step 18 between the base 16 and the distal portion 17 of the extended portion 1, the beveled and tapered portions 19 as guiding portions, a non-illustrated recess 23 as a mounting pad are formed in the front wiring pattern 13. In the patterning step of the back wiring pattern 21, the copper plate as a raw material is pressed into the back wiring pattern 21 having the opening 22.

In the joint step, adhesive sheets are adhered to the front surface and the back surface of the insulating layer 11. Then, the insulating layer 11 is overlain on the back wiring pattern 21. The front wiring pattern 13 is overlain on the adhesive sheet on the side of the front surface. Then, the laminate is pressed from both the front side and the back side by a vacuum press. By pressing, the back wiring pattern 21 is fixed to the back surface of the insulating layer 11 and the front wiring pattern 13 is fixed to the front surface of the insulating layer 11 to form the integral laminate 10A of the insulating layer 11, the front wiring pattern 13 and the back wiring pattern 21. As illustrated in Fig. 4B, the front surface and the back surface of the laminate 10A obtained by the joint step are flat surfaces without protrusions. The extended portion 15 of the front wiring pattern 13 extends straight toward the opening 22 of the insulating layer 11. A part of the striking 20 is located on the side of the opening 22. The extended portion 15 protrudes from the edge of the insulating layer 11 that faces the opening 12. Regarding the surface mounts of electronic components when using mounting pads, the electronic components are mounted on the laminate 10A by a mounter in the above state and reflow soldering is conducted. In this state, since the extended portion 15 does not protrude from the surface of the substrate, the extended portion 15 does not interfere with the above process of the surface mounts of the electronic components. After the electronic components are mounted on the laminate 10A, the process proceeds to the step of bending a pattern. In the step of bending a pattern, the extended portion 15 is bent to form a connection terminal T.

As illustrated in Fig. 4C, in the step of bending a pattern, the front surface of the laminate 10A including the striking 20 is pressed with a front surface pressing tool 31 while the back surface of the laminate 10A except for the opening 12 of the insulating layer 11 is pressed with a back surface pressing tool 32. Next, a punch 33 that can be moved up and down is opposed to the extended portion 15 from the back side of the laminate 10A. Then, the punch 33 is elevated. The punch 33 thus elevated contacts the lower surface of the extended portion 15 and the extended portion 15 is bent by the elevation of the punch 33.

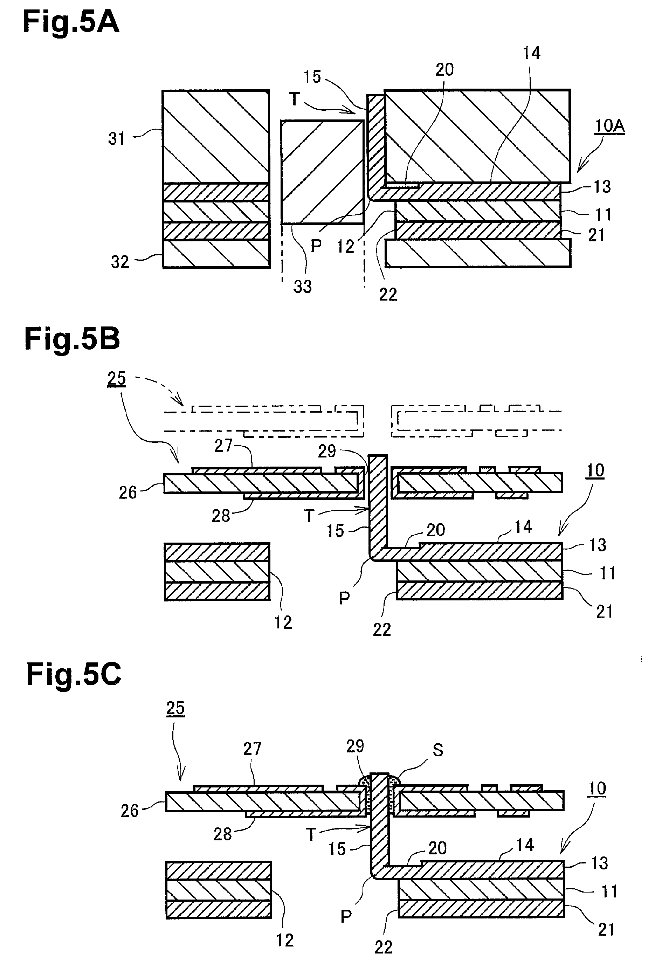

As illustrated in Fig. 5A, the extended portion 15 is bent on the way of the base 16 to extend along the end of the front surface pressing tool 31 by the elevation of the punch 33. The extended portion 15 includes the non-displaced portion from the proximal end to the bending position P and the displaced portion from the bending position P to the distal end, wherein the displaced portion is perpendicular to the non-displaced portion. Thus, the distal tip of the displaced portion protrudes from the outermost surface of the front wiring pattern 13. The distal tip of the displaced portion of the extended portion 15 is inserted into the insertion hole 29 at the time of connection with the substrate 25. Thus, in the step of bending a pattern, the extended portion 15 is bent to form the connection terminal T whereby the wiring substrate 10 having the connection terminal T is obtained.

Next, the step of connecting the substrate 25 with the wiring substrate 10 will be discussed. The extended portion 15 as bent above includes the connection terminal T. The substrate 25 is located with respect to the wiring substrate 10 so that the insertion hole 29 of the substrate 25 is positioned upward of the distal tip of the extended portion 15. After the substrate 25 is located with respect to the wiring substrate 10, the substrate 25 is made to descend to the wiring substrate 10. As illustrated in Fig. 5B, by descending the substrate 25, the tip of the extended portion 15 is inserted into the insertion hole 29 of the substrate 25. It can happen that the distal tip of the extended portion 15 and the insertion hole 29 of the substrate 25 are slightly offset relative to each other from predetermined positions. However, in this case, since the tapered portion 19 guides the connection terminal T with respect to the substrate 25, the distal tip of the extended portion 15 is inserted into the insertion hole 29 of the substrate 25. Although the substrate 25 is lower with respect to wiring substrate 10 in this embodiment, the wiring substrate 10 may be higher with respect to substrate 25 so that the connection terminal T of the wiring substrate 10 is inserted into the insertion hole 29 of the substrate 25.

Even if the distal tip of the extended portion 15 is inserted into the insertion hole 29 of the substrate 25, when the substrate 25 is lowered, the step 18 of the extended portion 15 abuts the substrate 25 to restrict further descent of the substrate 25. By the abutment of the step 18 with the substrate 25, the distance between the wiring substrate 10 and the substrate 25 is determined and the substrate 25 supports the extended portion 15. The distance between the wiring substrate 10 and the substrate 25 corresponds to the distance between the bending position P and the step 18 in the extended portion 15.

Next, as illustrated in Fig. 5C, the solder S is filled in the gap between the extended portion 15 and the insertion hole 29 of the substrate 25. By filling the solder S, the connection terminal T and the substrate 25 are physically fixed each other and the wiring substrate 10 and the substrate 25 are electrically connected. It is preferable that solder S is lead-free solder from in an environmental aspect.

The first embodiment has the following effects.
(1) By bending the extended portion 15 after the lamination of the wiring pattern 13, 21 and the insulating layer 11, the connection terminal T that protrudes from the surface of the substrate is formed. Thus, without adding the number of parts, a part of the wiring pattern can be used as the connection terminal T. In addition, since the connection terminal T is formed by bending the extended portion 15, the connection terminal T is less restricted by orientation with respect to the counterpart substrate 25. By connecting the bent connection terminal T, another component is unnecessary. In addition, since the mounting surface on the substrate is increased, electronic components can be mounted at higher density.
(2) The connection terminal T is bent in a direction perpendicular to the outermost surface of a substrate surface, which is the outermost surface of the extended portion 15 before the bending. Since the distal tip of the extended portion 15 forming the connection terminal T is perpendicular to the substrate surface, the position of the distal tip of the extended portion 15 is positioned with a high degree of freedom. The substrate 25 having the surface parallel with the substrate surface and the extended portion 15 are easily connected.
(3) The extended portion 15 includes a tapered portion 19 that guides the connection terminal T to the insertion hole 29 of the counterpart substrate 25. The tapered portion 19 serves as a guide for guiding the connection terminal T relative to the insertion hole 29 of the substrate 25. Even if the wiring substrate 10 and the substrate 25 are slightly offset from each other, since the tapered portion 19 guides the extended portion 15, the wiring substrate 10 and the substrate 25 are easily connected.
(4) The extended portion 15 includes the steps serving as supporting portions for supporting the substrate 25. The steps 18 can support the substrate 25 by abutting the back surface of the substrate 25 in the state where the extended portion 15 and the substrate 25 are connected. Thus, no additional member for supporting the substrate 25 is required in the wiring substrate 10.
(5) The wiring substrate 10 and the substrate 25 are electrically connected by connecting the extended portion 15 with the substrate 25 with the solder S. Even if there is a gap between the extended portion 15 and the insertion hole 29 into which the substrate 25 is inserted, the solder S is filled in the gap to connect the wiring substrate 10 and the substrate 25.
(6) The recess for preventing springback is formed in the extended portion 15 before the bending. Thus, even after the extended portion 15 is bent, the springback of the connection terminal T is prevented. The recess is the striking 20 produced by a strike process at the position to be bent in the extended portion 15. Thus, the springback of the connection terminal T can be prevented without increasing the number of parts.
(7) The connection terminal T is formed by bending the extended portion 15 after the lamination of the wiring pattern 13, 21 and the insulating layer 11. The laminate 10A before the connection terminal T is formed has flat surfaces without protrusions on both front side and back side. Thus, manipulation and handling of the laminate 10A during the manufacturing the substrate is advantageous, which contributes to an improvement in productivity for the wiring substrates 10.
(8) The wiring pattern 13, 21 are formed of copper plates and a mounting pad is formed in the wiring pattern 13. Thus, electronic components can be surface mounted on the wiring pattern 13. By bending the wiring pattern 13 after the surface mount of electronic components, the wiring pattern 13 can be used as a connection terminal having electronic components.

### (Second Embodiment)

Next, a wiring substrate according to the second embodiment will be described. In the wiring substrate of the second embodiment, a back wiring pattern includes an extended portion and the connection terminal is formed by bending the extended portion. Like elements as in the first embodiment are denoted as like numerals and explanation of such like elements are omitted.

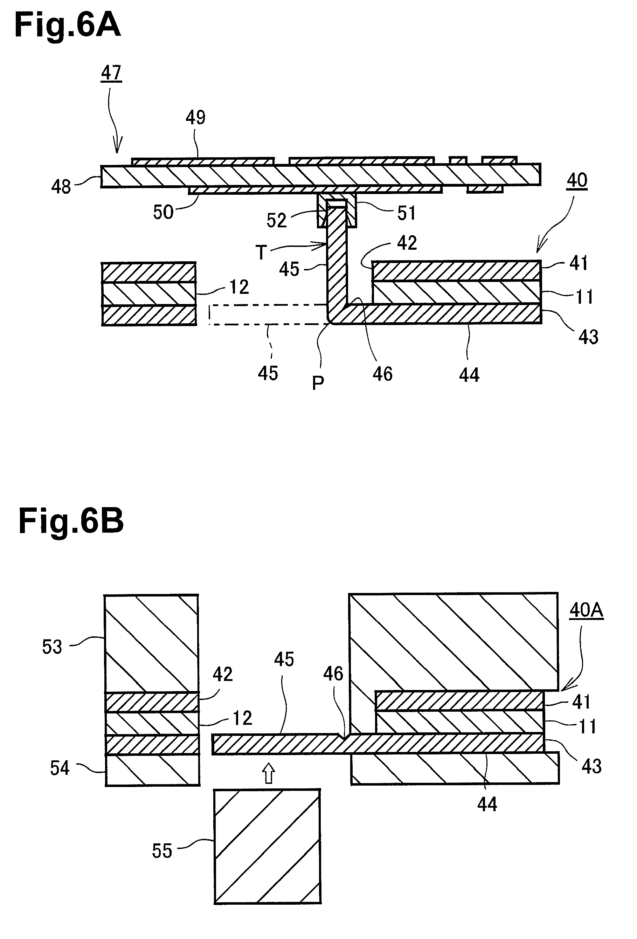

As illustrated in Fig. 6A, a front wiring pattern 41 of this embodiment is fixed to the upper surface of the insulating layer 11. The front wiring pattern 41 overlaps with the insulating layer 11 and includes an opening 42 that has the substantially the same shape as the opening 12 of the insulating layer 11. The front wiring pattern 41 and the back wiring pattern 43 may be electrically connected between the layers.

The back wiring pattern 43 includes a joint portion 44 that overlaps with the insulating layer 11 and an extended portion 45 that extends from the joint portion 44 toward the opening 12. The joint portion 44 is a portion of the back wiring pattern 43 that is fixed with the insulating layer 11 with an adhesive sheet. The extended portion 45 is non-overlapped portion that is not joined with the insulating layer 11. By bending the extended portion 45, the connection terminal T in the back wiring pattern 43 is formed.

The extended portion 45 of this embodiment has a certain width from the proximal tip to the distal tip. At the position to be bent in the extended portion 45, a wedge-shaped groove 46 is formed as a recess for correcting the shape to prevent springback. The wedge-shaped groove 46 is formed at the time of punching press of the back wiring pattern 43. The opening angle of the wedge-shaped groove 46 immediately after the formation is approximately 100°.

By bending the extended portion 45 perpendicularly on the way in the longitudinal direction, the distal end of the extended portion 45 orients upward and protrudes from the surface of the wiring substrate 40, more specifically, from the outermost surface of the front wiring pattern 41. The bending of the extended portion 45 is conducted after the integration of the insulating layer 11, the back wiring pattern 43 and the front wiring pattern 41. Provided that the bending position of the extended portion 45 is P, the extended portion 45 includes a non-displaced portion from the proximal tip to the bending position P and a bend displaced portion from the bending position P to the distal tip.

The wiring substrate 40 of this embodiment is connected to the substrate 47, which is another member, via the connection terminal T. The substrate 47 is formed by integration of an insulating layer 48, a front wiring pattern 49 and a back wiring pattern 50. The substrate 47 includes a fitting member 51 having a fitting hole 52 into which the connection terminal T of the wiring substrate 10 is fittable. The fitting hole 52 may fit with the distal end of the extended portion 45 forming the connection terminal T. Fitting of the distal end of the extended portion 45 and the fitting hole 52 of the fitting member 51 allows the connection terminal T and the substrate 47 to electrically connect to each other and allows the connection terminal T to support the substrate 47. Fixation of the connection terminal T and the substrate 47 by the fitting allows electrical conduction between the connection terminal T and the substrate 47.

A manufacturing process for the wiring substrate 40 according to the second embodiment includes a patterning step, a step of forming an insulating layer, a joint step, and a step of bending a pattern and each step is basically the same as the step in the first embodiment. In the second embodiment, the extended portion 45 of the back wiring pattern 43 is bent so that the distal end of the extended portion 45 forms the connection terminal T that orients upward. In the step of bending a pattern, a front surface pressing tool 53, a back surface pressing tool 54 and a punch 55 are used, as illustrated in Fig. 6B. A part of each of the front surface pressing tool 53 and the back surface pressing tool 54 has a structure to press near the proximal end of the extended portion 45.

In the step of bending a pattern, the front surface of the laminate 40A and near the proximal end of the extended portion 45 are pressed with the front surface pressing tool 53 while the back surface of the laminate 40A and the proximal end of the extended portion 45 are pressed with the back surface pressing tool 54. Thus, even if the extended portion 45 is bent, a gap is formed between the extended portion 45 and the front wiring pattern 49 after the bending whereby short between the extended portion 45 and the front wiring pattern 49 is prevented. A punch 55 that can be moved up and down is elevated to bend the extended portion 45. The extended portion 45 is bent on the way in the longitudinal direction to extend along the end of the front surface pressing tool 53. The extended portion 45 includes a non-displaced portion from the proximal end to the bending position P and a displaced portion from the bending position P to the distal end, wherein the displaced portion is perpendicular to the non-displaced portion. The distal tip of the displaced portion protrudes from the outermost surface of the front wiring pattern 41, which is a substrate surface.

The second embodiment has effects that are substantially the same as the effects (1), (2), (6) and (7) in the first embodiment. In addition, the second embodiment allows formation of the connection terminal T in the back wiring pattern 43 that protrudes from the surface of the front wiring pattern 41. Moreover, since a portion connected to the substrate 47 is a fitting member 51 having a fitting hole 52 and the wiring substrate 40 is connected with the substrate 47 by fitting the connection terminal T into the fitting hole 52, the connection of the connection terminal T and the substrate 47 is achieved without using solder.

### (Third Embodiment)

Next, a wiring substrate according to the third embodiment will be described. In the wiring substrate of the third embodiment, an internal wiring pattern provided between a plurality of insulating layers includes an extended portion. Like elements as in the first and second embodiments are denoted as like numerals and explanation of such like elements are omitted.

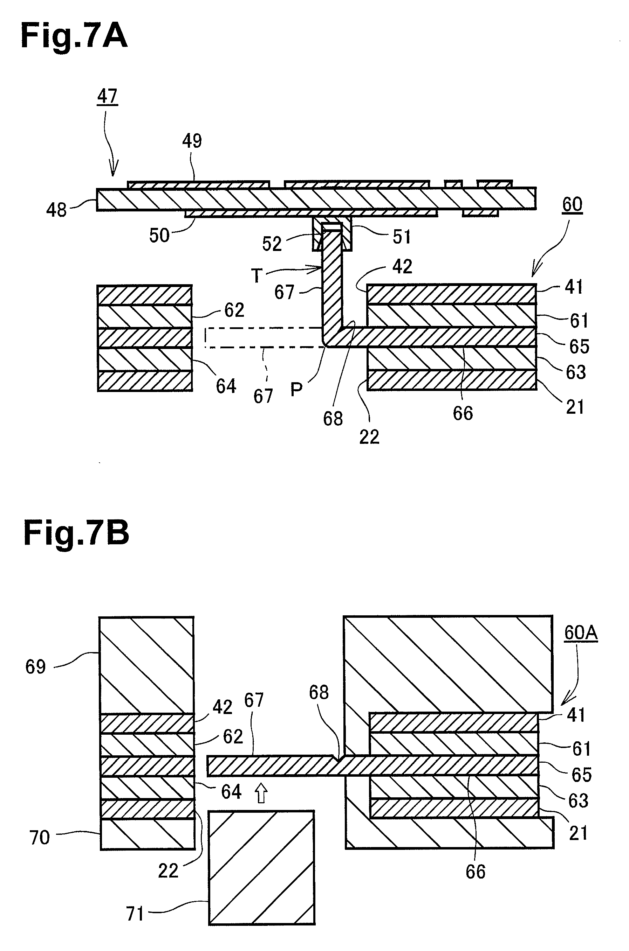

As illustrated in Fig. 7A, a wiring substrate 60 of this embodiment includes a front wiring pattern 41, a back wiring pattern 21, an internal wiring pattern 65, a first insulating layer 61 and a second insulating layer 63. The front wiring pattern 41 overlaps with the first insulating layer 61 and includes an opening 42 that is substantially the same as an opening 62 of the first insulating layer 61. The back wiring pattern 21 overlaps with the second insulating layer 63 and includes an opening 22 that is substantially the same as an opening 64 of the second insulating layer 63.

The internal wiring pattern 65 has substantially the same structure as the back wiring pattern 43 of the second embodiment. The internal wiring pattern 65 includes a joint portion 66 that overlaps with the first insulating layer 61 and the second insulating layer 63 and an extended portion 67 extending from the joint portion 66 toward the openings 62, 64. The joint portion 66 is sandwiched between the first insulating layer 61 and the second insulating layer 63 and fixed between them with adhesive sheets. The extended portion 67 does not overlap with the first insulating layer 61 and the second insulating layer 63 but forms a connection terminal T of the internal wiring pattern 65 by bending.

The extended portion 67 of this embodiment has a certain width from the proximal tip to the distal tip. At the position to be bent in the extended portion 67, a wedge-shaped groove 68 is formed by a wedge process for correcting the shape to prevent springback. The wedge-shaped groove 68 is formed at the time of punching press of the internal wiring pattern 65. The wedge-shaped groove 68 has the same configuration as the wedge-shaped groove 46 of the second embodiment.

By bending the extended portion 67 perpendicularly on the way, the distal end of the extended portion 67 is oriented upward and protrudes from the surface of the wiring substrate 60, more specifically, from the outermost surface of the front wiring pattern 41. The bending of the extended portion 67 is conducted after the integration of the first insulating layer 61, the second insulating layer 63, the back wiring pattern 21, the front wiring pattern 41 and the internal wiring pattern 65. Provided that the bending portion of the extended portion 67 is P, the extended portion 67 includes a non-displaced portion from the proximal tip to the bending position P and a bend displaced portion from the bending position P to the distal tip.

The wiring substrate 60 of this embodiment is connected to the substrate 47, which is another member, via the connection terminal T. The substrate 47 of this embodiment has the same configuration as the substrate 47 of the second embodiment. The substrate 47 includes a fitting member 51 having a fitting hole 52 as a member to be connected. Fitting of the distal end of the extended portion 67 and the fitting hole 52 of the fitting member 51 allows the connection terminal T and the substrate 47 to fix each other.

A manufacturing process for the wiring substrate 60 according to the third embodiment includes a patterning step, a step of forming the insulating layers, a joint step, and a step of bending a pattern and each step is basically the same as the step in the first embodiment. In the joint step, the back wiring pattern 21, the second insulating layer 63, the internal wiring pattern 65, the first insulating layer 61 and the front wiring pattern 41 are stacked in turn from the back and pressure is applied from both the front side and the back side to form the laminate 60A.

In this embodiment, the extended portion 67 of the internal wiring pattern 65 is bent so that the distal end of the extended portion 67 forms the connection terminal T that orients upward. In the step of bending a pattern, a front surface pressing tool 69, a back surface pressing tool 70 and a punch 71 are used, as illustrated in Fig. 7B. A part of each of the front surface pressing tool 69 and the back surface pressing tool 70 has a structure to press near the proximal end of the extended portion 67. Thus, even if the extended portion 67 is bent, a gap is formed between the extended portion 67 and the front wiring pattern 41 after the bending whereby short between the extended portion 67 and the front wiring pattern 41 is prevented.

In the step of bending a pattern, the front surface of the laminate 60A and near the proximal end of the extended portion 67 are pressed with the front surface pressing tool 69 while the back surface of the laminate 60A and the proximal end of the extended portion 67 are pressed with the back surface pressing tool 70. A punch 71 that can be moved up and down is elevated to bend the extended portion 67. The extended portion 67 is bent on the way in the longitudinal direction to extend along the end of the front surface pressing tool 69. The extended portion 67 includes a non-displaced portion from the proximal end to the bending position P and a displaced portion from the bending position P to the distal end, wherein the displaced portion is perpendicular to the non-displaced portion. The distal tip of the displaced portion protrudes from the outermost surface of the front wiring pattern 41, which is a substrate surface. Thus, the extended portion 67 is bent to form the connection terminal T whereby the wiring substrate 60 having the connection terminal T is obtained.

The third embodiment has effects that are substantially the same as the effects (1), (2), (6) and (7) in the first embodiment. In addition, the third embodiment allows formation of the connection terminal T in the internal wiring pattern 65 that protrudes from the surface of the front wiring pattern 41. Moreover, since the wiring substrate 60 is connected with the substrate 47 by fitting the connection terminal T into the fitting hole 52, the connection of the connection terminal T and the substrate 47 is achieved without using solder.

The wiring substrate of each of the above embodiments is an embodiment of the invention. The invention is not limited to each of the above embodiments but may be modified within the spirit and scope of the invention as follows.

In the first to third embodiments, a single extended portion is extended toward the opening. However, a plurality of the extended portions may be extended toward the openings. In addition, in the first to third embodiments, although the extended portion on the side of the opening extends in the longitudinal direction of the wiring substrate, the extended portion may extend in any direction with respect to the opening. For example, the extended portion may extend in the width direction of the wiring substrate.

In the first to third embodiments, the opening of the insulating layer is rectangular. However, the shape of the opening in the insulating layer is not particularly limited. The opening in the insulating layer may be circular or irregular, or a U-shaped opening in a plan view in which one side is open.

In the first to third embodiments, the distal tip of the connection terminal formed from a specific wiring pattern protrudes from the front surface of the substrate (outermost surface of the front wiring pattern). However, the distal tip of each connection terminal may protrude from the back surface of the substrate (outermost surface of the back wiring pattern). In addition, in the wiring substrate, a number of wiring patterns greater than the wiring patterns of the third embodiment may be formed, and the plurality of the wiring patterns may form the respective connection terminals in one opening. When the substrate surface of the wiring substrate is not formed from the joint portion but formed from the insulating layer, the distal tip of the extended portion may protrudes from the surface of the insulating layer as an outermost surface.

In the first to third embodiments, the connection terminal formed from a specific wiring pattern is bent so that the distal portion (displaced portion) is oriented perpendicularly to the proximal portion (non-displaced portion). However, the bend is not limited to perpendicular. For example, as long as the distal portion of the connection terminal protrudes from the substrate surface, the distal portion may incline. In addition, the extended portion may be curved to form the connection terminal.

In the first to third embodiments, the wiring substrate is connected to the substrate as another member. However, the another member is not limited to the substrate but may be other parts such as an electronic part and a jumper as long as it is connectable with the connection terminal.

In the first to third embodiments, the insulating layer has an opening and the extended portion extends toward the opening of the insulating layer. However, the opening of the insulating layer is not necessarily required. For example, the extended portion may protrude from the edge of the insulating layer.

In the first to third embodiments, the extended portion is a "cantilever" having a distal portion that extends toward the opening of insulating layer. However, for example, the extended portion may be "an extended portion supported at both ends". In this case, a center of the extended portion is pressed to bend and deform the extended portion thereby forming the connection terminal having a distal tip at the center. The distal tip of the connection terminal protrudes from the outermost surface of the insulating layer or the joint portion.

In the first to third embodiments, the opening of the wiring pattern and the opening of the insulating layer are substantially the same. However, the openings of the wiring pattern and the insulating layer are not limited to substantially the same shape. For example, the opening of the wiring pattern and the opening of the insulating layer may have different shapes.

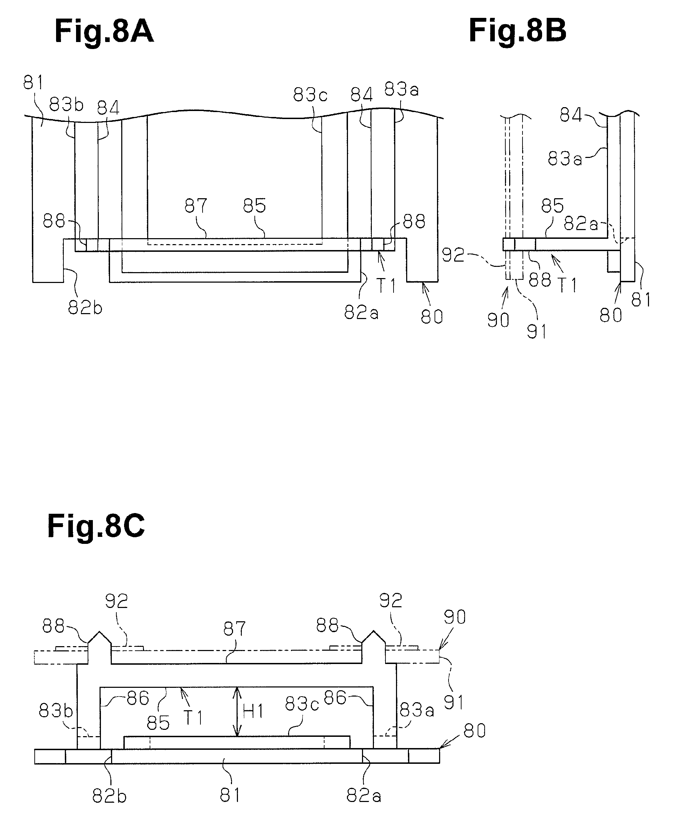

As illustrated in Fig. 8A to 8C, the connection terminal T1 may include jumper line(s) that connects a wiring pattern 83a in one section fixed to the insulating layer 81 and a wiring pattern 83b in another section fixed to the insulating layer 81 in a jumping way. The connection terminal T1 allows connection between the wiring pattern 83a and wiring pattern 83b as a jumper connection.

In particular, as illustrated in Fig. 8C, the connection terminal T1 includes a pair of standing portions 86, a horizontal portion 87 connecting upper ends of the pair of the standing portions 86, and a pair of connecting portions 88 extending upward from the upper surface of the horizontal portion 87. A substrate 90 as another member is placed on the upper surface of the horizontal portion 87.

The wiring substrate 80 includes wiring patterns 83a, 83b and 83c and an insulating layer 81 to which the wiring patterns 83a, 83b and 83c are fixed. The wiring patterns 83a, 83b and 83c are pressed copper plates (in a wider sense, conductive plates) and connected to the insulating layer 81 with an adhesive agent. Each of the wiring patterns 83a, 83b includes a joint portion 84 that connects with the insulating layer 81 and an extended portion 85 that extends from the joint portion 84 and protrudes an edge of the insulating layer 81. By pending the extended portion 85, a connection terminal T1 is provided where a part of the extended portion 85 may protrude from the outermost surface of the joint portion 84.

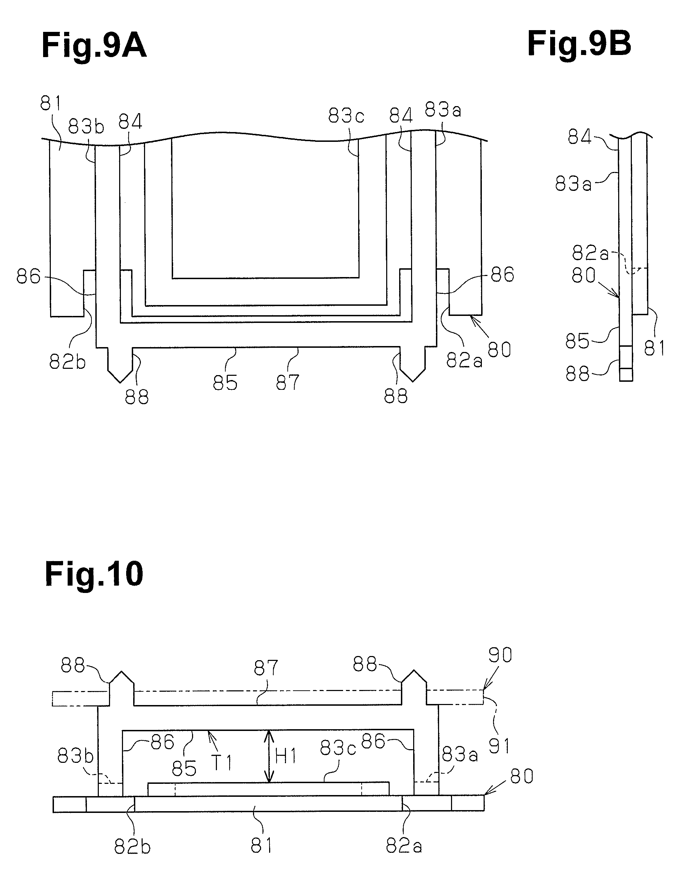

The insulating layer 81 includes rectangular openings 82a and 82b that extends through the insulating layer 81. That is, in one side of the rectangular insulating layer 81, the openings 82a and 82b, which are rectangular cutouts, are formed at a distance. The bases of the extended portion 85 are located in the opening 82a and 82b. The connection terminal T1 is bent perpendicular to the insulating layer 81 (or the outermost surface of the joint portion). That is, by bending a flat cupper pattern before the bending as illustrated in Fig. 9A with a punch, the connection terminal T forming a jumper line is made to stand as illustrated in Fig. 8C so that a jumper line bridging the copper or wiring pattern 83C is formed.

The connecting portions 88 of Figs. 8A to 8C extend through the insulating layer 91 of the substrate 90, which is another member. The connecting portions 88 are connected with the wiring patterns 92 formed on the upper surface of the insulating layer 91 with solder. Each connecting portion 88 has a tapered portion in which the width of the extended portion 85 becomes narrower toward the distal tip of the connection terminal T1 (i.e., the connecting portion 88 has a sharpened distal tip).

The connection terminal T1 forming a jumper line bridges over the wiring pattern 83c at a certain distance. The wiring pattern 83c is different from the wiring pattern 83a in one section and the wiring pattern 83b in another section at a certain distance. As particularly shown in Fig. 8C, the horizontal portion 87 of the connection terminal T1 is spaced at a distance H1 from the wiring pattern 83c fixed to the insulating layer 81 in the direction perpendicular to the surface of the insulating layer 81. For example, the distance H1 is 2mm. Thus, an insulating distance (or spatial distance) is obtained between the jumper line (horizontal portion 87) and the wiring pattern 83c to ensure the safety electrical insulation. Accordingly, the connection terminal T1 forming the jumper line and the wiring pattern 83c can be isolated securely.

In Figs. 8A to 8C, the connection terminal T1 is used to electrically and mechanically connect the wiring substrate 80 with the substrate 90, which is another member, with a solder. Instead, another embodiment as illustrated in Fig. 10 may be used. That is, each connecting portion 88 of the connection terminal T1 is inserted into a corresponding through-hole formed in the substrate 90 to locate the substrate 90 on the upper surface of the horizontal portion 87. Thus, the substrate 90 may be mechanically connected with the wiring substrate 80 (i.e., the substrate 90 may be connected with the wiring substrate 80 in the located state).

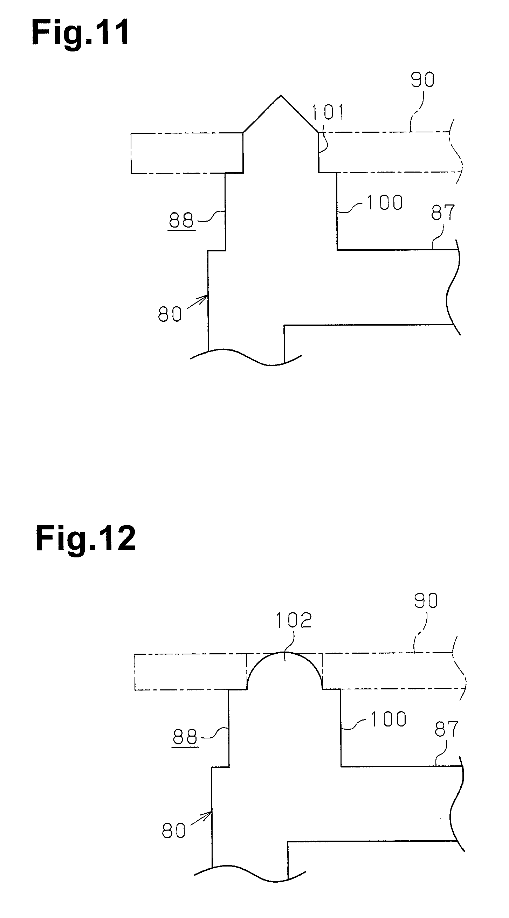

In Figs. 8A to 8C, the substrate 90 as another member is positioned on the upper surface of the horizontal portion 87. However, in the case where the wiring pattern exists on the lower surface of the substrate 90 in the region of the horizontal portion 87 (i.e., in the case where it is possible that short occurs between the horizontal 87 and the wiring pattern on the lower surface of the substrate 90), another embodiment as illustrated in Fig. 11 may be used. The connecting portion 88 may includes a wide portion 100 that has a greater width than the distal portion 101 and the substrate 90 may be positioned on the wide portion 100. In this case, the connecting portion 88 may have a tapered distal portion 101 or round distal portion 102 as illustrated in Fig. 12.

In Figs. 8A to 8C, the wiring substrate may have the wiring pattern 83c that is not located underneath the jumper line or the horizontal portion 87.

## Claims

1. A wiring substrate comprising:
a wiring pattern; and
an insulating layer to which the wiring pattern is fixed, wherein the insulating layer includes an edge,
wherein the wiring pattern includes:
a joint portion connected with the insulating layer; and
an extended portion that extends from the joint portion and protrudes from the edge of the insulating layer,
wherein the insulating layer or the joint portion includes an outermost surface, and
wherein a connection terminal is provided by bending the extended portion so that a part of the extended portion is protruded from the outermost surface of the insulating layer or the joint portion.

2. The wiring substrate of claim 1 wherein the insulating layer includes an opening that extends through the insulating layer, wherein the extended portion is located at the opening.

3. The wiring substrate of claim 1 or 2 wherein the connection terminal is bent in a direction perpendicular to the outermost surface of the insulating layer or the joint portion.

4. The wiring substrate of any one of claims 1 to 3 wherein the connection terminal has a distal tip, and the extended portion has sides and each side has a tapered portion so that the width of the extended portion becomes smaller toward the distal tip of the connection terminal.

5. The wiring substrate of any one of claims 1 to 4 wherein the connection terminal has a distal portion, and the extended portion includes a wide portion having a greater width than the distal portion of the connection terminal.

6. The wiring substrate of any one of claims 1 to 5 wherein the connection terminal is connected with another member by soldering.

7. The wiring substrate of any one of claims 1 to 6 wherein the wiring pattern is a pressed conductive plate and joined with the insulating layer with an adhesive agent.

8. The wiring substrate of any one of claims 1 to 7 wherein the extended portion has a recess at the position to be bent.

9. The wiring substrate of claim 8 wherein the recess includes a striking or a wedge-shaped groove.

10. The wiring substrate of any one of claims 1 to 9 wherein the wiring pattern is made of a metal plate.

11. The wiring substrate of any one of claims 1 to 10 wherein a mounting pad is formed in the wiring pattern.

12. The wiring substrate of any one of claims 1 to 11 wherein the wiring pattern includes a wiring pattern in one section fixed to the insulating layer and a wiring pattern in another section fixed to the insulating layer, wherein the connection terminal forms a jumper line connecting the wiring pattern in one section and the wiring pattern in another section.

13. The wiring substrate of claim 12, wherein the connection terminal forming the jumper line bridges over a wiring pattern at a certain distance that is different from the wiring pattern in one section and the wiring pattern in another section.
